# EUROPÄISCHE PATENTANMELDUNG

(11) **EP 4 261 246 A1**
(43) Veröffentlichungstag der Anmeldung: **18.10.2023**
(21) Anmeldenummer: 22167781.8
(22) Anmeldetag: 12.04.2022
(51) Int. Cl.: C08J 7/04, B05D 5/06, B32B 15/08, C23C 14/00, C23C 18/38

(54) **VERBESSERUNG DER KORROSIONSBESTÄNDIGKEIT KUPFERBASIERTER METALLISIERUNGSSCHICHTEN SOWIE HERSTELLUNG VON BAUTEILEN MIT SOLCHEN SCHICHTEN**

(71) Anmelder: WEIDPLAS GmbH, 8630 Rüti (CH)
(72) Erfinder: Heintz, Benedikt, 66117 Saarbrücken (DE); Jung, Thomas, 66346 Püttlingen (DE); Kurz, Alexander, 66663 Merzig (DE)
(74) Vertreter: Rutz, Andrea

(57) **Zusammenfassung**

Es wird ein Bauteil mit korrosionsbeständiger Kupferbeschichtung angegeben, das ein Trägerteil (1) aus Kunststoff, eine auf das Trägerteil (1) aufgebrachte Farbschicht (3), eine auf die Farbschicht (3) aufgebrachte transluzente oder transparente Korrosionsschutzschicht (4) sowie eine auf die Korrosionsschutzschicht (4) aufgebrachte Deckschicht (5, 6) aufweist. Die Farbschicht (3) ist aus Kupfer oder aus einer Kupferlegierung mit einem Kupferanteil von mindestens 30%, wie insbesondere Bronze oder Messing, hergestellt. Die Korrosionsschutzschicht (4) ist transluzent oder transparent ausgebildet und aus einem oder mehreren der Elemente AI, Sc, V, Fe, Nb, Mo, Cr, Zr, Ti, Ag, Hf, Ta, W, Au, Pt oder deren Legierungen hergestellt. Die Deckschicht (5, 6) ist transluzent oder transparent ausgebildet. Die Korrosionsschutzschicht (4) ist direkt auf der Farbschicht (3) aufgebracht. Des Weiteren wird ein Verfahren zur Herstellung eines solchen korrosionsbeständigen Bauteils angegeben.

## Beschreibung

### TECHNISCHES GEBIET

Die vorliegende Erfindung betrifft ein Bauteil mit korrosionsbeständiger Kupferbeschichtung sowie ein Verfahren zur Herstellung eines derartigen Bauteils.

### STAND DER TECHNIK

In verschiedensten Bereichen der Technik werden beschichtete Bauteile eingesetzt, die beim Betrachter den Eindruck einer Metalloberfläche oder einer Oberfläche mit einer bestimmten Farbgebung bewirken sollen. Die Oberfläche des Bauteils kann dabei je nachdem einen matten oder einen glänzenden Eindruck bewirken. Derartige Bauteile werden beispielsweise im Automobilbau in Form von Zier- oder Einstiegsleisten eingesetzt oder zum Beispiel als Abdeckelemente bei Haushaltgeräten oder Konsumgütern.

Um ein Bauteil mit einer metallischen Oberfläche zu versehen, ist es bekannt, ein zum Beispiel aus Kunststoff hergestelltes Trägerteil mit einer Galvanikschicht zu überziehen. Metallische Oberflächen verleihen dem Bauteil einen besonders hochwertigen Eindruck. Die Galvaniktechnik hat jedoch den Nachteil eines verhältnismässig hohen Aufwandes, was die Massenfertigung von derartigen Bauteilen erschwert. Nachteilig bei Galvanikverfahren ist zudem der Bedarf an toxikologisch kritischen Substanzen, welche hinsichtlich ihrer Verwendung zunehmend stärkeren Restriktionen durch den Gesetzgeber unterliegen.

Bei metallischen Oberflächen stellt sich, insbesondere wenn sie einen hohen Kupferanteil haben, das Problem der Korrosionsanfälligkeit. Um das Bauteil widerstandsfähiger gegenüber Umgebungseinflüssen zu machen werden die metallischen Oberflächen von derartigen Bauteilen im Stand der Technik deshalb oft mit einer Deckschicht überzogen, die eine Schutzschicht bildet, um die darunterliegende Metallschicht vor Korrosion zu schützen. Gängige Deckschicht-Materialien, wie insbesondere transparente Lacke, weisen jedoch keine ausreichend starke Barrierewirkung auf. Zudem hängt der Korrosionsschutz dann erheblich von der Intaktheit der Deckschicht ab, was bedeutet, dass zum Beispiel bereits geringste mechanische Beschädigungen der Deckschicht zu Unterwanderungswirkungen führen können. Teile der Metallbeschichtung können dadurch dennoch zu korrodieren beginnen, was in fortgeschrittenem Stadium zu Abplatzungen von ganzen Bereichen der Beschichtung führen kann.

Beispielsweise wird in der EP 3 498 879 A1 ein Verfahren vorgeschlagen zur Herstellung eines korrosionsbeständigen Bauteils. Dabei wird auf ein metallisches oder nicht-metallisches Substrat eine Grundierungsschicht aufgebracht, deren Oberfläche Plasma- oder Corona-behandelt wird, bevor darauf mittels Aufdampf-Technik eine Metallschicht angebracht wird. Die Metallschicht wird ebenfalls Plasma- oder Corona-behandelt und anschliessend mit einer Deckschicht überzogen.

Die EP 3 117 907 A1 offenbart ein Verfahren zur Herstellung eines beschichteten Bauteils, bei welchem eine Metallschicht auf ein Kunststoffsubstrat aufgedampft wird. Die Metallschicht wird anschliessend mit einer siliziumorganischen Verbindung behandelt, um eine Polysiloxanschicht auszubilden. Auf die Polysiloxanschicht wird eine Deckschicht aufgetragen.

In der EP 3 225 717 A1 wird ein Beschichtungsverfahren offenbart, bei dem ein Matt- oder Glanzlack auf ein Kunststoffsubstrat aufgetragen und anschliessend mindestens eine Metallschicht auf den Lack aufgedampft wird. Auf die Metallschicht wird eine transparente oder eingefärbte Deckschicht aufgetragen.

In der EP 1 454 999 A1 wird ein Bauteil angegeben, bei dem eine Beschichtung aus einer oder mehreren Metallschichten direkt auf einer Kunststoffoberfläche aufgebracht ist, die bei der Herstellung allenfalls vorlackiert sein kann. Die Metallschichten bestehen dabei aus wenigstens einem Metall ausgewählt aus den Elementen von allen Gruppen 4 bis 14 des Periodensystems, Legierungen und/oder Edelstahl.

Die EP 3 498 883 A1 offenbart ein Verfahren zur Herstellung eines korrosionsbeständigen Bauteils, bei welchem eine erste und eine zweite Metallschicht mittels Aufdampf-Technik auf ein nicht-metallisches Substrat aufgebracht und anschliessend mit einer transparenten Deckschicht überzogen werden. Um eine gute Haftung der Schichten aneinander zu erreichen, wird zwischen den Metallschichten eine Grundierungsschicht vorgesehen. Ausserdem wird die erste Metallschicht einer Plasma- oder Corona-Behandlung unterzogen. Als Materialien wird für die erste und die zweite Metallschicht jeweils eine Liste mit einer Vielzahl von in Frage kommende Metallen und Legierungen angegeben.

Bei den oben erwähnten Verfahren bzw. Bauteilen des Standes der Technik wird zum Erreichen von guten Haftverbindungen zwischen den Schichten jeweils eine Plasma- oder Coronabehandlung der entsprechenden Schichtoberflächen durchgeführt und/oder eine Grundierungs- oder ein Haftvermittler wird zwischen den jeweiligen Schichten vorgesehen. Dies ist jedoch mit beträchtlichem Zusatzaufwand verbunden.

Insbesondere Bauteile mit Metallbeschichtungen, die aus Kupfer oder aus einer Kupferlegierung mit einem hohen Kupferanteil hergestellt sind, sind einerseits aufgrund ihrer charakteristischen Farbgebung besonders attraktiv, stellen aufgrund der ausgeprägten Korrosionsanfälligkeit von Kupfer jedoch eine besondere Herausforderung dar.

### DARSTELLUNG DER ERFINDUNG

Es ist also eine Aufgabe der vorliegenden Erfindung, ein einfach herstellbares Bauteil mit einem Trägerteil aus Kunststoff und einer aus Kupfer oder aus einer Kupferlegierung hergestellten Farbschicht anzugeben, die besonders gut vor Korrosion und anderen Umwelteinflüssen geschützt ist.

Zur Lösung dieser Aufgabe wird ein Bauteil mit korrosionsbeständiger Kupferbeschichtung vorgeschlagen, wie es in Anspruch 1 angegeben ist. Ausserdem wird in Anspruch 12 ein Verfahren zur Herstellung eines solchen Bauteils angegeben. Bevorzugte Ausführungsformen sind in den abhängigen Ansprüchen angegeben.

Die vorliegende Erfindung stellt also ein Bauteil mit korrosionsbeständiger Kupferbeschichtung zur Verfügung, aufweisend
ein Trägerteil aus Kunststoff, mit einer optional darauf angebrachten Primerschicht;
eine auf das Trägerteil aufgebrachte Farbschicht, welche aus Kupfer oder aus einer Kupferlegierung mit einem Kupferanteil von mindestens 30%, bevorzugt von mindestens 50%, wie insbesondere Bronze oder Messing, hergestellt ist;
eine auf die Farbschicht aufgebrachte transluzente oder transparente Korrosionsschutzschicht, welche aus einem oder mehreren der Elemente Al (Aluminium), Sc (Scandium), V (Vanadium), Fe (Eisen), Nb (Niob), Mo (Molybdän), Cr (Chrom), Zr (Zirkonium), Ti (Titan), Ag (Silber), Hf (Hafnium), Ta (Tantal), W (Wolfram), Au (Gold), Pt (Platin) oder deren Legierungen hergestellt ist; sowie
eine auf die Korrosionsschutzschicht aufgebrachte transluzente oder transparente Deckschicht.

Erfindungsgemäss ist die Korrosionsschutzschicht dabei direkt auf der Farbschicht aufgebracht.

Indem die Korrosionsschutzschicht direkt auf der Farbschicht aufgebracht ist, wird ein besonders effektiver Korrosionsschutz erreicht. Der Korrosionsschutz wird durch die Ausbildung der Korrosionsschutzschicht aus einem oder mehreren der Elemente Al, Sc, V, Fe, Nb, Mo, Cr, Zr, Ti, Ag, Hf, Ta, W, Au, Pt oder deren Legierungen in Kombination mit der direkten Anordnung der Korrosionsschutzschicht auf der Farbschicht bewirkt. Das in der Farbschicht enthaltene Kupfer ist dadurch selbst bei einer Beschädigung der Deckschicht optimal geschützt. Es hat sich herausgestellt, dass eine sehr gute Haftung der Korrosionsschutzschicht auf der aus Kupfer bzw. einer Kupferlegierung hergestellten Farbschicht erreicht werden kann, wenn diese direkt, das heisst unmittelbar bzw. ohne Zwischenschichten, aneinander angebracht sind. Es müssen hierzu keine Haftvermittler oder andere zusätzliche Materialien oder Schichten vorgesehen werden. Durch die direkte Aufbringung der Korrosionsschutzschicht auf der Farbschicht, das heisst durch die direkte Kontaktierung der Farbschicht durch die Korrosionsschutzschicht, können zudem auch Unterwandungseffekte und damit zusammenhängende Abplatzungen weitgehend vermieden werden.

Das massgebende farbgebende Material der Farbschicht ist in der Regel das Kupfer bzw. die Kupferlegierung. Kupfer und Kupferlegierungen haben spezifische Eigenfarben, die beim angegebenen Bauteil besonders gut zur Geltung kommen können. So hat eine aus Kupfer hergestellte Farbschicht je nach Kupferanteil und Lichteinstrahlung üblicherweise einen charakteristischen rosa, orangen und/oder roten Farbton. Falls die Farbschicht aus einer Kupferlegierung hergestellt ist, hat sie, falls es sich bei der Kupferlegierung um Messing handelt, meist einen charakteristischen gelben Farbton. Falls es sich bei der Kupferlegierung um Bronze handelt, weist diese in der Regel den für Bronze typischen goldähnlichen, leicht rötlichen Farbton auf. Beim angegebenen Bauteil können diese erwähnten Farbtöne gut zur Geltung gebracht werden. Dabei erwirkt das Bauteil beim Betrachter, bevorzugt bei Betrachtung von vorne, insbesondere einen metallischen Eindruck.

Der charakteristische Farbton der Farbschicht ist bei Kupferlegierungen erkennbar, wenn der Kupferanteil bei mindestens 30% liegt, und kommt besonders gut zu Geltung, wenn der Kupferanteil bei mindestens 50% liegt.

Als besonders gut geeignet hat sich eine Korrosionsschutzschicht erwiesen, die aus Chrom oder einer Chromlegierung oder aus Zirkonium oder aus einer Zirkoniumlegierung hergestellt ist. Eine aus diesen Metallen hergestellte Korrosionsschutzschicht lässt sich zudem gut und fest haftend auf der Farbschicht aufbringen und ist zudem verhältnismässig kostengünstig. Aus denselben Gründen gut geeignet ist eine Korrosionsschutzschicht, die aus Aluminium oder einer Aluminiumlegierung oder aus Titan oder einer Titanlegierung hergestellt ist.

Die Herstellung des Trägerteils aus einem Kunststoff ist besonders vorteilhaft, da dadurch nicht nur eine kostengünstige Massenproduktion des Trägerteils und somit des Bauteils ermöglicht wird, sondern da das Trägerteil dadurch hinsichtlich seiner Formgebung flexibel gestaltet werden kann. Insbesondere kann das Trägerteil im Spritzgussverfahren hergestellt sein, was auch die Herstellung von Trägerteilen mit komplexen dreidimensionalen Formen ermöglicht. Der Kunststoff, aus welchem das Trägerteil hergestellt ist, kann insbesondere einen Thermoplasten aufweisen oder aus einem Thermoplasten bestehen. Bevorzugt handelt es sich beim Kunststoff um ein AcrylnitrilButadien-Styrol-Copolymer ABS (opak / transluzent), bzw. um ABS/PC (Polycarbonat) (opak / transluzent). Der Vorteil von ABS bzw. ABS/PC liegt insbesondere in der guten Haftung der Beschichtungen am Trägerteil. Es ist aber auch PC (opak / transluzent / transparent) oder Polymethylmethacrylat (PMMA) (opak / transluzent / transparent) möglich. Das Trägerteil kann auch aus mehreren Materialkomponenten hergestellt sein, wobei die verschiedenen Komponenten dann vorteilhaft ähnliche Wärmeausdehnungen haben. Das Material des Trägerteils kann Füllstoffe aufweisen, wie z.B. Partikel oder Fasern, welche insbesondere zum Angleichen der Ausdehnungskoeffizienten von unterschiedlichen Materialkomponenten dienen können. Bevorzugt wird im Randbereich von auf dem Trägerteil aufgebrachten PVD-Schichten ein Kunststoff für das Trägerteil verwendet, an welchem die PVD-Schichten besonderes gut haften, also zum Beispiel ABS, ABS/PC und/oder PC.

Das Trägerteil weist üblicherweise eine derartige Eigenstabilität auf, dass es bevorzugt für die Farbschicht, noch bevorzugter für das Bauteil insgesamt, formgebend ist. Je nach Ausführungsform kann es sich beim Trägerteil aber auch um eine Folie handeln.

Das Trägerteil weist bevorzugt eine Dicke von 1 Millimeter oder grösser auf. Dadurch ist eine gewisse strukturelle Stabilität des Trägerteils gewährleistet. Um Materialkosten zu sparen, weist das Trägerteil bevorzugt jedoch eine maximale Dicke von 10 Millimeter auf. Insbesondere falls das Trägerteil aus thermoplastischem Kunststoff im Spritzguss hergestellt ist, weist das Trägerteil bevorzugt eine maximale Dicke von 10 Millimeter auf.

Das Trägerteil ist bevorzugt als Ganzes einstückig ausgebildet. Es kann ein- oder mehrschichtig ausgebildet sein.

Bevorzugt ist die Farbschicht auf der Vorderseite des Trägerteils aufgebracht. Die Vorderseite wird durch diejenige Seite des Trägerteils gebildet, welche bei bestimmungsgemässer Verwendung des Bauteils üblicherweise dem Betrachter zugewandt ist. Bevorzugt ist die Farbschicht bei bestimmungsgemässer Verwendung des Bauteils üblicherweise für einen Betrachter sichtbar, das heisst der Betrachter erkennt die von der Farbschicht bewirkte Farbgebung des Bauteils. Die Farbschicht ist bevorzugt somit zu einer Sichtseite des Bauteils hin gewandt. Als weitere Ausführungsform kann die Farbschicht auch auf der Rückseite des Trägerteils angebracht sein. Das Trägerteil ist in diesem Fall bevorzugt aus einem transparenten oder transluzenten Material hergestellt.

Die Farbschicht überdeckt die Vorderseite des Trägerteils, also die bei bestimmungsgemässer Verwendung dem Betrachter zugewandten Bereiche des Trägerteils bevorzugt zu zumindest 25 Prozent, bevorzugter zu zumindest 50 Prozent, noch bevorzugter zu zumindest 75 Prozent, und noch bevorzugter zu zumindest 95 Prozent. Am bevorzugtesten überdeckt die Farbschicht jedoch die gesamte Vorderseite des Trägerteils vollständig, also sämtliche bei bestimmungsgemässer Verwendung dem Betrachter zugewandten Bereiche des Trägerteils. Diese Angaben gelten analog für eine rückseitige Beschichtung des Trägerteils.

Auf der Farbschicht, kann, muss aber nicht, eine Schicht zur Farbjustierung angeordnet sein. Die Schicht zur Farbjustierung kann insbesondere dazu dienen, den von der Farbschicht bewirkten Farbton fein zu justieren. Der durch die Farbschicht bewirkte charakteristische Farbton des Kupfers bzw. der Kupferlegierung bleibt dadurch für den Betrachter bevorzugt aber ohne Weiteres erkennbar. Alternativ oder zusätzlich zu einer Schicht zur Farbjustierung kann zu demselben Zweck auch die Farbschicht und/oder die Deckschicht eingefärbt sein. Je nachdem können die Schicht zur Farbjustierung und/oder die Deckschicht als Diffusor ausgebildet sein, um ein gleichmässigeres Erscheinungsbild des Bauteils zu erreichen. Falls eine Schicht zur Farbjustierung vorhanden ist, ist diese bevorzugt mittels physikalischer Gasphasenabscheidung (eng. physical vapour deposition, PVD) auf der Farbschicht aufgebracht.

Transluzent ist ein Material, ein Körper oder eine Schicht dann, wenn sie Licht teilweise durchlassen, so dass durch das Material, den Körper oder die Schicht hindurch zum Beispiel erkennbar ist, ob ein dahinter angeordnetes Leuchtelement leuchtet oder nicht. Das Licht kann beim Durchtritt durch das Material, den Körper bzw. die Schicht aber gestreut werden, so dass zum Beispiel spezielle Formen, Symbole oder Schriftzüge nicht mehr erkennbar sind. Oft wird transluzentes Material auch als "halbtransparent" bezeichnet. Im Gegensatz dazu ist ein Material, ein Körper oder eine Schicht dann transparent, wenn Licht weitgehend ungehindert und ohne wesentliche Streuung durch das Material, den Körper oder die Schicht hindurch gelangen kann, so dass dahinter angeordnete Formen, Symbole oder Schriftzüge für einen Betrachter weiterhin als solche erkennbar sind. Transparentes Material kann auch als bild- oder blickdurchlässig bzw. durchsichtig bezeichnet werden.

Indem die Korrosionsschutzschicht und die Deckschicht jeweils transluzent oder transparent ausgebildet sind, ist die Farbschicht sichtbar und die von ihr bewirkte Farbgebung des Bauteils somit erkennbar. Bevorzugt überdeckt die Korrosionsschutzschicht die gesamte Farbschicht vollständig.

Die Deckschicht, welche im Falle eines Lackes auch als Topcoat bezeichnet werden kann, dient bevorzugt dazu, die Widerstandsfähigkeit des Bauteils gegenüber externen Einflüssen zu erhöhen und/oder eine bestimmte optische Wirkung zu erzielen. Vorteilhaft zeichnet sich das Material der Deckschicht gegenüber der Farb- und/oder der Korrosionsschutzschicht deshalb als besonders kratzfest, chemisch beständig, glänzend und/oder matt aus. Die Deckschicht bildet bevorzugt die vorderste, das heisst äusserste Schicht, des Bauteils. Die Deckschicht bildet dadurch bevorzugt die Sichtseite des Bauteils. Die Schichtdicke der Deckschicht liegt bevorzugt bei 10 - 40 µm.

Falls die Korrosionsschutzschicht aus einer Metalllegierung eines der Elemente AI, Sc, V, Fe, Nb, Mo, Cr, Zr, Ti, Ag, Hf, Ta, W, Au, Pt hergestellt ist, weist diese einen Metallanteil dieses spezifischen Metalls von bevorzugt mindestens 25%, bevorzugter mindestens 50%, am bevorzugtesten mindestens 75%, auf. Dadurch ist ein guter Korrosionsschutz gewährleistet.

Falls die Korrosionsschutzschicht aus einer Chromlegierung oder aus einer Zirkoniumlegierung hergestellt ist, weist diese somit einen Chrom- bzw. Zirkoniumanteil von bevorzugt mindestens 25%, bevorzugter mindestens 50%, am bevorzugtesten mindestens 75%, auf. Ein Bauteil, das eines dieser beiden Metalle und insbesondere Metallanteile in der Korrosionsschutzschicht aufweist, hat sich als besonders beständig und vorteilhaft in Bezug auf praktische Anwendungen erwiesen.

Die Deckschicht kann aus einer oder mehreren Schichten, insbesondere aus einer oder mehreren aus Lack hergestellten Schichten, gebildet sein. Bei einer Deckschicht, welche aus mehreren Schichten hergestellt ist, sind die jeweiligen Schichten vorteilhaft aus unterschiedlichen Materialien hergestellt. Die Schichten, welche zusammen die Deckschicht bilden, können unterschiedliche oder identische Brechungsindizes aufweisen. Die Brechungsindizes können insbesondere von Schicht zu Schicht alternieren. Bei unterschiedlichen Brechungsindizes kann Licht bei seiner Ausbreitung länger in den jeweiligen Schichten verbleiben. Bei identischen Brechungsindizes kann das Licht hingegen einfacher von Schicht zu Schicht gelangen. Je nach Ausführungsform kann das eine oder das andere gewünscht sein. Eine mehrlagige Deckschicht kann alternativ auch zum Beispiel aus verschiedenen Kunststoffschichten oder alternierend aus einer mehrfachen Abfolge von jeweils einer Kunststoffschicht, welche kein Lack ist, und einer Lackschicht bestehen. In gewissen Ausführungsformen kann die oberste Schicht eine Transportschutzfolie bilden, welche ablösbar von den restlichen Schichten der Deckschicht ausgebildet ist und zum Schutz des Bauteils bei der Lagerung und beim Transport dient.

Die Deckschicht ist vorteilhaft als Ganzes einstückig ausgebildet. Bevorzugt überdeckt sie die gesamte Korrosionsschutzschicht vollständig.

Je nach Einsatzweck des Bauteils kann die Deckschicht aus unterschiedlichen Materialien hergestellt sein, um dem Bauteil als Ganzes und der darunterliegenden Farb- und Korrosionsschutzschicht im Besonderen einen guten Schutz zu bieten. So kann die Deckschicht beispielsweise aus einem bevorzugt thermisch oder mittels UV (Ultraviolettlicht) härtendem Lack hergestellt sein. Zur Herstellung der Deckschicht kann ein In-Mould-Verfahren (Spritzguss) verwendet werden oder sie kann mit einem anderen Verfahren, z.B. mittels Plasmabehandlung, hergestellt werden. Auch kann die Deckschicht zum Beispiel mittels chemischer Gasphasenabscheidung (CVD) zur Abscheidung von z.B. Siliciumdioxid(SiO₂)-haltigem Material hergestellt werden.

Bevorzugt ist die Deckschicht über ihre gesamte Flächenerstreckung im Wesentlichen gleich dick. Dies bietet den Vorteil, dass die Sichtseite des Bauteils einen homogenen Eindruck erweckt. Die Deckschicht kann über ihre Flächenerstreckung aber auch eine variierende Dicke aufweisen. Dies ermöglicht die Erzeugung von verschiedensten Designeffekten. So können durch Variation der Dicke der Deckschicht zum Beispiel unterschiedliche Helligkeiten an der Sichtseite des Bauteils erzielt werden, wie z.B. indem das die Deckschicht bildende Material entsprechend eingefärbt ist. Alternativ oder zusätzlich kann die Deckschicht zudem lokale Erhebungen und/oder Vertiefungen aufweisen, welche zum Beispiel Symbole, Buchstabe, Schriftzüge oder Piktogramme darstellen können.

In der Regel sind das Trägerteil, falls vorhanden die Primerschicht, die Farbschicht, die Korrosionsschutzschicht und die Deckschicht fest miteinander verbunden, so dass sie nur mittels Zerstörung wieder voneinander getrennt werden können.

Beim Bauteil kann es sich zum Beispiel um ein Automobilbauteil, insbesondere um ein Anbauteil, handeln. Das Automobilbauteil kann dabei für Interieur- oder Exterieur-Anwendungen dienen. Beispielsweise kann es sich beim Bauteil um ein Dekorelement, wie insbesondere eine Einstiegs- oder Zierleiste, handeln. Das Bauteil kann aber auch zur Verwendung bei Konsumgütern, insbesondere bei Konsumgüterelektronik, ausgebildet sein. Weitere Verwendungen des Bauteils sind beispielsweise im Bereich von Sportartikeln, Sanitärbauteilen oder Haushaltsgeräten denkbar. Bei den Haushaltsgeräten kann es sich zum Beispiel um Waschmaschinen, Geschirrspüler, Kühlschränke, Wäschetrockner, Kochherd oder Kaffeemaschinen oder um sog. "Weisse Ware" im Allgemeinen handeln. Das Bauteil kann z.B. auch eine Leiste oder ein Emblem bilden, welches einen Schriftzug oder ein Symbol trägt, um beispielsweise auf einen Hersteller oder eine Marke hinzuweisen.

In einer insbesondere bevorzugten Ausführungsform sind die Farbschicht und/oder die Korrosionsschutzschicht mittels physikalischer Gasphasenabscheidung (eng. physical vapour deposition, PVD) aufgebracht. Die Farbschicht ist somit bevorzugt mittels PVD auf das Trägerteil aufgebracht. PVD hat im Vergleich zur Galvaniserung den wesentlichen Vorteil, dass giftige Chemikalien, wie z. B. Cr (VI) und Ni (II), vermieden werden können. Metallische PVD-Schichten weisen darüber hinaus technische Vorteile auf, wie z.B. eine höhere Flexibilität, die Möglichkeit der Hinterleuchtbarkeit und eine einfachere Strukturierung mittels Laserabtrag. Die Aufbringung mittels PVD hat zudem den Vorteil, dass eine gute Haftung zwischen dem Kunststoff-Trägerteil und der aus Kupfer oder aus einer Kupferlegierung hergestellten Farbschicht erreicht werden kann. Ausserdem kann dadurch der Materialaufwand für die Farbschicht minimiert werden. Galvanisch hergestellte Schichten haben demgegenüber den Nachteil, dass weitere Schichten nur schlecht oder gar nicht darauf haften. Besonders bevorzugt ist auch die Korrosionsschutzschicht mittels PVD auf der Farbschicht aufgebracht. Die Korrosionsschutzschicht kann dadurch bzgl. ihrer Dicke genau eingestellt werden, so dass zum Beispiel einerseits ein guter Korrosionsschutz erreicht wird und andererseits die optischen Eigenschaften der Farbschicht nicht oder nur zu einem geringen Mass verändert werden. Die genaue Einstellung der Schichtdicke der Farbschicht und/oder der Korrosionsschutzschicht bei der PVD-Auftragung bringt den weiteren Vorteil mit sich, dass die Lichtdurchlässigkeit der entsprechenden Schicht(en) sehr genau und wie gewünscht eingestellt werden kann. Durch die PVD-Auftragung kann zudem eine gute Haftung der Korrosionsschutzschicht an der Farbschicht erreicht werden.

Bevorzugt ist die Korrosionsschutzschicht derart ausgebildet, dass sie im L*a*b-Farbraum die von einem Betrachter wahrgenommene Farbe der Farbschicht um einen Farbvektor verändert, der kürzer ist als 10 ΔE-Einheiten, insbesondere kürzer ist als 6 ΔE-Einheiten. Die von der Korrosionsschutzschicht bewirkte Farbveränderung ist dadurch für einen Betrachter kaum (< 10 ΔE-Einheiten) oder gar nicht (< 6ΔE-Einheiten) zu erkennen.

Gemäss einer Weiterbildung der Erfindung weist die Korrosionsschutzschicht eine Schichtdicke auf von 2 - 5 nm, bevorzugt von 2 - 4 nm, insbesondere bevorzugt von 3 - 3.5 nm (Nanometer). Eine Korrosionsschutzschicht in diesem Schichtdickenbereich hat den Vorteil, dass einerseits die antikorrosive Wirkung gewährleistet ist, und dass andererseits keine Änderung bzgl. der Farbe der Farbschicht wahrgenommen wird. Bei einer Schichtdicke von weniger als 2 nm ist der Korrosionsschutz üblicherweise nicht ausreichend. Wenn die Korrosionsschutzschicht mindestens 3 nm dick ist, kann der Korrosionsschutz in der Regel auch langfristig gewährleistet werden. Bereits bei einer Schichtdicke der Korrosionsschutzschicht von mehr als 3.5 nm ist diese vom Betrachter je nach Lichteinfall erkennbar. Ab einer Schichtdicke der Korrosionsschutzschicht von mehr als 4 nm wird vom Betrachter in der Regel eine Veränderung der Farbe der Farbschicht festgestellt. Wenn die Korrosionsschutzschicht mehr als 5 nm dick ist, ist die Farbveränderung für den Betrachter meist sogar deutlich wahrnehmbar.

Je nach Ausführungsform kann die Farbschicht eine gleichbleibende oder eine variierende Schichtdicke aufweisen. Eine variierende Schichtdicke bewirkt unterschiedliche Lichtdurchlässigkeiten, was zur Erzielung von bestimmten optischen Effekten erwünscht sein kann.

In einer besonders bevorzugten Ausführungsform ist die Oberfläche der Farbschicht, auf welcher die Korrosionsschutzschicht aufgebracht ist, bzgl. der Oberflächenenergie unbehandelt und wurde insbesondere weder einer Corona- noch einer Plasmabehandlung unterzogen. Es wurde festgestellt, dass eine Behandlung der Oberfläche bei einem direkten Aufbringen der Korrosionsschutzschicht auf die Farbschicht nicht notwendig ist, um eine ausreichende Schichthaftung zu erreichen. Dies ist insbesondere dann der Fall, wenn die Korrosionsschutzschicht mittels PVD auf der Farbschicht aufgebracht ist. Indem keine Behandlung der Oberflächenenergie der Farbschicht notwendig ist, kann die Herstellung des Bauteils erheblich vereinfacht werden, was ein erheblicher Vorteil des angegebenen Bauteils darstellt.

Bevorzugt weist sogar keine der Schichten des Bauteils eine Oberflächenbehandlung, wie insbesondere eine Plasma- oder Coronabehandlung, auf. Auch das Trägerteil muss somit bzgl. seiner Oberflächenenergie vor dem Aufbringen der Farbschicht nicht vorbehandelt werden. Zur Verbesserung der Haftung der Farbschicht (oder der Primerschicht; siehe weiter unten) kann die Oberfläche des Trägerteils aber aufgerauht sein.

Die Deckschicht ist bevorzugt aus einem Lack, zum Beispiel aus einem Klarlack, hergestellt. Lack schützt die darunterliegenden Schichten in der Regel besonders gut vor Umwelteinflüssen. Ausserdem kann Lack das Bauteil optisch ansprechend beeinflussen, wie zum Beispiel dem Bauteil einen Glanz oder ein mattes Aussehen verleihen. Bevorzugt ist die Deckschicht im Sprühverfahren hergestellt. Eine andere Möglichkeit zum Aufbringen der Deckschicht stellt das Spritzgussverfahren dar. Dadurch kann sehr einfach eine ausreichende Schichtdicke und gewünschte Formgebung erreicht werden.

Die Farbschicht kann direkt auf der Vorderseite des Trägerteils aufgebracht sein, das heisst diese kontaktieren. Je nach Ausführungsform kann es aber bevorzugt sein, dass zwischen dem Trägerteil und der Farbschicht eine Primerschicht vorgesehen ist, welche als Haftvermittler und/oder zur Ausgleichung von Oberflächenunebenheiten dient. Falls das Bauteil eine Primerschicht aufweist, wird somit die Farbschicht direkt auf die Primerschicht aufgebracht. Besonders gute Resultate wurden erzielt, wenn die Primerschicht aus einem Lack hergestellt ist. Bevorzugt handelt es sich beim Lack um einen UV-härtenden oder um einen thermisch härtenden Lack. Bevorzugt wird die Primerschicht aufgesprüht. Grundsätzlich wäre es aber auch möglich, dass die Primerschicht im Spritzgussverfahren hergestellt, insbesondere an das Trägerteil angespritzt wird. Alternativ kann die Primerschicht zum Beispiel mittels Extrusion hergestellt oder aufgesprüht sein. Vorteilhaft weist die Primerschicht eine Schichtdicke auf von 5 - 30 µm, insbesondere von 10- 15 µm (Micrometer). Bei einer solchen Schichtdicke können Oberflächenunebenheiten sehr gut ausgeglichen werden.

Die Farbschicht weist bevorzugt eine Schichtdicke auf von 20 - 200 nm, insbesondere von 40 - 100 nm. Es hat sich herausgestellt, dass mit einer solchen Schichtdicke bei wenig Materialverbrauch eine gute optische Wirkung erzielt werden kann. Bei kleineren Schichtdicken, insbesondere bis maximal 60 nm, ist die Farbschicht lichtdurchlässig. Bei grösseren Schichtdicken, insbesondere ab 60 nm, wirkt die Farbschicht opak. Je nach Ausführungsform kann das eine oder das andere gewünscht sein.

Die Deckschicht ist bevorzugt direkt auf der Korrosionsschutzschicht aufgebracht, das heisst es sind zwischen Korrosionsschutzschicht und Deckschicht keine Zwischenschichten vorhanden.

Vorteilhaft weist die Farbschicht eine Vorderseite und eine Rückseite auf, welche von einer Seitenfläche der Farbschicht miteinander verbunden sind. Vorteilhaft weist die Korrosionsschutzschicht eine Vorderseite und eine Rückseite auf, welche von einer Seitenfläche der Korrosionsschutzschicht miteinander verbunden sind. Vorteilhaft weist die Primerschicht (falls vorhanden) eine Vorderseite und eine Rückseite auf, welche von einer Seitenfläche der Primerschicht miteinander verbunden sind. Vorteilhaft weist die Deckschicht eine Vorderseite und eine Rückseite auf, welche von einer Seitenfläche der Deckschicht miteinander verbunden sind.

Vorteilhaft sind die Seitenfläche der Farbschicht sowie die Seitenfläche der Korrosionsschutzschicht vollständig von der Vorderseite des Trägerteils überdeckt. Falls zwischen dem Trägerteil und der Farbschicht eine Primerschicht angeordnet ist, so ist vorteilhaft die Seitenfläche der Primerschicht vollständig von der Vorderseite des Trägerteils überdeckt. Vorteilhaft ist die Seitenfläche der Deckschicht zumindest teilweise von der Vorderseite des Trägerteils überdeckt. Durch die Überdeckung der Seitenflächen der Schichten sind die Schichten besonders gut vor externen Einflüssen geschützt.

Vorteilhaft sind die Seitenfläche der Farbschicht sowie die Seitenfläche der Korrosionsschutzschicht vollständig von der Rückseite des Trägerteils überdeckt. Falls zwischen dem Trägerteil und der Farbschicht eine Primerschicht angeordnet ist, so ist vorteilhaft die Seitenfläche der Primerschicht vollständig von der Rückseite des Trägerteils überdeckt. Vorteilhaft ist die Seitenfläche der Deckschicht zumindest teilweise, vorteilhafter vollständig, von der Rückseite des Trägerteils überdeckt. Gemäss einer weiteren Ausführungsform ist die Seitenfläche der Deckschicht von der Rückseite des Trägerteils nicht überdeckt. Durch die Überdeckung der Seitenfläche der Schichten sind die Schichten besonders gut vor externen Einflüssen geschützt.

Gemäss einer Weiterbildung der Erfindung sind die Farbschicht und/oder das Trägerteil transluzent oder transparent ausgebildet. Das Bauteil kann dann ausserdem ein Leuchtelement aufweisen, um das Bauteil durch die Farbschicht hindurch zu hinterleuchten. Auf diese Weise ist somit eine Hinterleuchtung durch die aus Kupfer bzw. einer Kupferlegierung hergestellte Farbschicht hindurch möglich, was besondere optische Effekte bewirken kann. Eine Hinterleuchtung durch die Farbschicht hindurch ist insbesondere dann gut möglich, wenn diese mittels PVD auf das Trägerteil aufgebracht ist und deshalb ausreichend dünn ausgebildet ist, um den Lichtdurchtritt zu ermöglichen. Die Hinterleuchtung kann von der Rückseite zur Vorderseite des Trägerteils oder auch von einer Seitenfläche zur Vorderseite des Trägerteils erfolgen. Das Trägerteil bildet dann bevorzugt einen Lichtleiter, der vorteilhaft zur Verteilung des eingestrahlten Lichts dient. Das Leuchtelement kann aber auch im Inneren des Trägerteils oder zwischen Trägerteil und Farbschicht angeordnet sein.

Das Leuchtelement kann insbesondere durch eine oder mehrere Leuchtdioden (LED's) ausgebildet sein. Die Leuchtdioden können einzeln oder zum Beispiel auf einer gemeinsamen Platine angeordnet sein. Das Leuchtelement kann aber auf ein flächiges Leuchtelement wie zum Beispiel eine OLED-Folie, eine Elektrolumineszenzfolie oder ein Display sein.

Gemäss einer Weiterbildung der Erfindung weist das Trägerteil und/oder, falls vorhanden die Primerschicht, und/oder die Farbschicht und/oder die Korrosionsschutzschicht und/oder die Deckschicht des Bauteils eine oder mehrere Lichtumlenkstrukturen auf. Durch das Vorsehen von Lichtumlenkstrukturen kann eine gezielte Lichtumlenkung des von einem Leuchtelement ausgestrahlten Lichtes in eine oder mehrere bestimmte Richtungen oder in einen oder mehrere bestimmte Richtungsbereiche erreicht werden. Dadurch, dass die von den Lichtumlenkstrukturen bewirkte Lichtumlenkung gezielt in eine oder mehrere bestimmte Richtungen oder in einen oder mehrere bestimmte Richtungsbereiche erfolgt, können vielfältige spezielle Effekte erzeugt werden, um die Aufmerksamkeit des Betrachters noch besser auf das Bauteil zu lenken. Darüber hinaus kann das vom Leuchtelement ausgestrahlte Licht auf besonders effiziente Art und Weise benutzt werden.

Die eine oder die mehreren Lichtumlenkstrukturen sind bevorzugt in oder am Trägerteil, falls vorhanden in oder an der Primerschicht, in oder an der Farbschicht, in oder an der Korrosionsschutzschicht und/oder in oder an der Deckschicht angeordnet. Verluste bei der Lichtausbreitung können dadurch minimiert werden. Beispielsweise können die Lichtumlenkstrukturen als lokale chemische oder physikalische, im Inneren oder an einer Oberfläche angeordnete Materialveränderungen oder als Oberflächenstrukturen in Form von lokalen Oberflächenerhebungen und/oder -vertiefungen vorgesehen sein. Die Oberflächenstrukturen können insbesondere als Grenzflächenstrukturen zwischen zwei Schichten ausgebildet sein und dann zusätzlich zur besseren Anbindung der beiden Schichten aneinander dienen. Auch das Einbringen von Fremdmaterialien oder von Lufteinschlüssen zur Ausbildung der Lichtumlenkstrukturen ist denkbar. Die Lichtumlenkstrukturen können insbesondere mittels eines Lasers erzeugt sein.

Das Leuchtelement kann ein Teil des Bauteils darstellen. Das Leuchtelement kann insbesondere an der Rückseite des Trägerteils angeordnet sein, um die Farb- und Deckschicht durch das transparent oder transluzent ausgebildete Trägerteil hindurch zu hinterleuchten. Alternativ oder zusätzlich kann das Leuchtelement auch im Bereich eines im Trägerteil vorgesehenen Durchbruchs angeordnet sein, um die Farb- und Deckschicht durch den Durchbruch hindurch zu hinterleuchten. An der Hinterseite des Trägerteils kann zum Beispiel auch ein Lichtleiter angeordnet sein, um das vom Leuchtelement ausgestrahlte Licht zum transparent oder transluzent ausgebildeten Trägerteil und/oder zu den mehreren Durchbrüchen zu verteilen. Alternativ kann das Leuchtelement auch als ein flächiges Leuchtelement, wie beispielsweise eine Leuchtfolie, wie zum Beispiel eine Elektrolumineszenzfolie oder eine OLED-Folie, ausgebildet sein, welche auf der Hinterseite des Trägerteils angeordnet ist.

Besondere optische Effekte und insbesondere die Anzeige von Symbolen, Buchstaben, Schriftzügen, Piktogrammen etc. sind möglich, wenn das Trägerteil und/oder, falls vorhanden die Primerschicht und/oder die Farbschicht und/oder die Deckschicht bereichsweise opak und bereichsweise transparent oder transluzent ausgebildet ist. Wenn zum Beispiel die Farbschicht und das Trägerteil oder aber die Farbschicht und die Deckschicht gemeinsam eine Sichtseite des Bauteils bilden, ist es aber auch möglich, dass die Farbschicht opak und das Trägerteil transparent oder transluzent ausgebildet ist (oder umgekehrt) bzw. die Deckschicht opak und die Farbschicht transparent oder transluzent ausgebildet (oder umgekehrt) ist, um zum Beispiel Symbole, Buchstaben, Schriftzüge, Piktogramme etc. darzustellen.

An der Rückseite des Trägerteils kann eine Vertiefung ausgebildet sein, in welche ein Leuchtelement und/oder ein Sensor aufgenommen sein kann. Das Leuchtelement bzw. der Sensor ist dann besonders leicht montierbar und besonders gut vor Umwelteinflüssen geschützt. Das Leuchtelement und/oder der Sensor kann sogar teilweise oder vollständig im Inneren des Trägerteils angeordnet sein. Dabei kann das Leuchtelement und/oder der Sensor insbesondere vom Material des Trägerteils wenigstens teilweise, bevorzugt vollständig, umhüllt, insbesondere umspritzt, sein. Das Trägerteil bildet dann in Bezug auf das Leuchtelement bzw. Sensor eine Schutzumhüllung, welche im Falle des Leuchtelements vorzugsweise transparent oder transluzent ausgebildet ist.

Das Trägerteil weist bei bestimmungsgemässer Verwendung üblicherweise eine Vorderseite und eine Rückseite sowie eine das Trägerteil zumindest teilweise, vorzugsweise vollständig, seitlich umrandende Seitenfläche auf, welche die Vorderseite mit der Rückseite verbindet. Je nach Ausführungsform können die Farbschicht und die Korrosionsschutzschicht, allenfalls auch die Deckschicht, jeweils sowohl die Vorderseite als auch die Seitenfläche des Trägerteils zumindest teilweise oder sogar vollständig überdecken. In gewissen Ausführungsformen können die Farbschicht und die Korrosionsschutzschicht, allenfalls auch die Deckschicht, zudem jeweils auch die Rückseite zumindest teilweise oder sogar vollständig überdecken.

Vorteilhaft sind das Trägerteil, die Farbschicht sowie die Korrosionsschutzschicht in ein Gehäuse eingefasst, welches die Seitenflächen des Trägerteils, der Farbschicht und der Korrosionsschutzschicht jeweils vollständig überdeckt, wobei vorteilhaft die Seitenfläche der Deckschicht zumindest teilweise vom Gehäuse überdeckt ist. Falls zwischen dem Trägerteil und der Farbschicht eine Primerschicht angeordnet ist, so ist die Primerschicht vorteilhaft in das Gehäuse eingefasst, welches die Seitenfläche der Primerschicht vollständig überdeckt. Bevorzugt ist das Trägerteil aus einem transluzenten oder transparenten Material hergestellt. Vorteilhaft weist diese Anordnung ein Leuchtelement auf, welches derart angeordnet ist, dass das Bauteil durch das transluzent oder transparent ausgebildete Trägerteil sowie die Farbschicht hindurch hinterleuchtbar ist. In diesem Fall ist das Gehäuse bevorzugt aus einem opaken Material ausgebildet, so dass dadurch insbesondere verhindert wird, dass Licht seitlich aus dem Bauteil austritt. Die Anordnung von Trägerteil und Gehäuse ist vorteilhaft mittels eines Mehrkomponentenspritzgussverfahrens, insbesondere mittels eines Zweikomponentenspritzgussverfahrens, hergestellt, wobei das Gehäuse an das Trägerteil oder das Trägerteil an das Gehäuse angespritzt ist.

Die Erfindung bezieht sich ausserdem auf ein Verfahren zur Herstellung eines Bauteils mit korrosionsbeständiger Kupferbeschichtung, welches insbesondere wie oben ausgeführt ausgebildet sein kann. Das Verfahren weist zumindest die folgenden Verfahrensschritte auf:
- Aufbringen einer Farbschicht aus Kupfer oder aus einer Kupferlegierung mit einem Kupferanteil von mindestens 30%, bevorzugt von mindestens 50%, wie insbesondere Bronze oder Messing, auf ein Trägerteil aus Kunststoff; sowie
- Aufbringen einer transluzenten oder transparenten Korrosionsschutzschicht aus einem oder mehreren der Elemente Al, Sc, V, Fe, Nb, Mo, Cr, Zr, Ti, Ag, Hf, Ta, W, Au, Pt oder deren Legierungen auf der Farbschicht;
- Aufbringen einer transluzenten oder transparenten Deckschicht auf der Korrosionsschutzschicht.

Die Korrosionsschutzschicht wird dabei direkt und bevorzugt mittels PVD auf der Farbschicht aufgebracht.

Bevorzugt erfolgt das Aufbringen der Korrosionsschutzschicht auf die Farbschicht zeitlich unmittelbar nach dem Aufbringen der Farbschicht auf das Trägerteil. Ausserdem bevorzugt erfolgt das Aufbringen der Deckschicht auf die Korrosionsschutzschicht zeitlich unmittelbar nach dem Aufbringen der Korrosionsschutzschicht auf die Farbschicht. Unter einem zeitlich unmittelbar danach erfolgenden Aufbringen einer Schicht wird verstanden, dass zwischen dem Aufbringen der ersten Schicht und dem Aufbringen der zweiten Schicht keine weiteren Zwischenschritte am Bauteil vorgenommen werden, das heisst es werden keine weiteren Schichten oder anderen Elemente am Bauteil angebracht. Unter einem zeitlich unmittelbar nacheinander erfolgenden Auftragen von Schichten kann insbesondere auch verstanden werden, dass das Bauteil während des PVD-Auftrags der jeweiligen Schichten jeweils demselben Vakuum ausgesetzt ist, d.h. das Vakuum bleibt von einer Auftragung zur nächsten im Wesentlichen unverändert und das Bauteil wird dazwischen dem Vakuum nicht entnommen. Nach dem Aufbringen der Farbschicht auf das Trägerteil wird die Korrosionsschutzschicht bevorzugt innerhalb von weniger als einer Minute, noch bevorzugter innerhalb von weniger als 30s, auf die Farbschicht aufgebracht.

### KURZE BESCHREIBUNG DER ZEICHNUNGEN

Bevorzugte Ausführungsformen der Erfindung werden im Folgenden anhand der Zeichnungen beschrieben, die lediglich zur Erläuterung dienen und nicht einschränkend auszulegen sind. In den Zeichnungen zeigen:
- Fig. 1: eine Schnittansicht eines schematisch dargestellten Bauteils mit korrosionsbeständiger Kupferbeschichtung gemäss einer ersten erfindungsgemässen Ausführungsform, wobei das Bauteil hinterleuchtbar ist;
- Fig. 2: eine Schnittansicht eines schematisch dargestellten Bauteils mit korrosionsbeständiger Kupferbeschichtung gemäss einer zweiten erfindungsgemässen Ausführungsform, mit Primerschicht;
- Fig. 3: eine Schnittansicht eines schematisch dargestellten Bauteils mit korrosionsbeständiger Kupferbeschichtung gemäss einer dritten erfindungsgemässen Ausführungsform, welches ein Trägerteil mit vollständig überdeckter Seitenfläche und teilweise überdeckter Rückseite aufweist;
- Fig. 4: eine Schnittansicht eines schematisch dargestellten Bauteils mit korrosionsbeständiger Kupferbeschichtung gemäss einer vierten erfindungsgemässen Ausführungsform, wobei das Bauteil hinterleuchtbar ist und zwei Deckschichten aufweist;
- Fig. 5: eine Schnittansicht eines schematisch dargestellten Bauteils mit korrosionsbeständiger Kupferbeschichtung gemäss einer fünften erfindungsgemässen Ausführungsform, wobei das Bauteil mittels im Trägerteil integrierten Leuchtelementen hinterleuchtbar ist; sowie
- Fig. 6: ein Flussdiagramm zur Veranschaulichung des erfindungsgemässen Verfahrens zur Herstellung eines Bauteils mit korrosionsbeständiger Kupferbeschichtung.

### BESCHREIBUNG BEVORZUGTER AUSFÜHRUNGSFORMEN

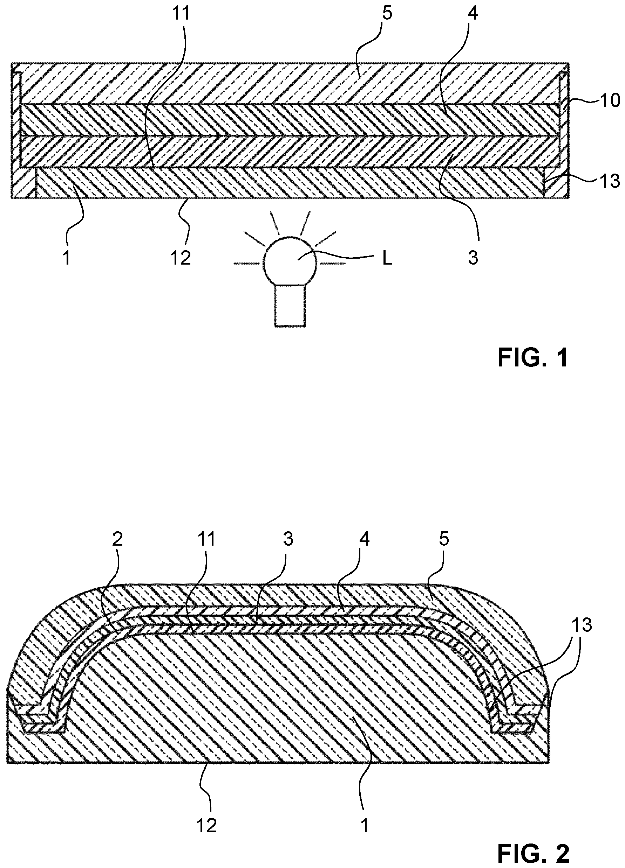

In den Figuren 1 bis 5 sind unterschiedliche Ausführungsformen von erfindungsgemässen Bauteilen mit korrosionsbeständiger Kupferbeschichtung jeweils in Form einer zentralen, schematischen Schnittansicht beispielhaft illustriert. Merkmale, welche eine identische oder zumindest ähnliche Ausgestaltung und/oder Funktion aufweisen, sind in den Figuren 1 bis 5 jeweils mit denselben Bezugszeichen versehen. Die dargestellten Ausführungsformen dienen lediglich zur Illustration von möglichen Varianten von erfindungsgemässen Bauteilen. Einzelne oder mehrere Elemente der verschiedenen Ausführungsformen sind beliebig mit den Elementen von anderen Ausführungsformen kombinierbar. Die dargestellten Ausführungsformen und Herstellverfahren sind in keiner Weise als einschränkend zu verstehen.

In der Figur 1 ist eine Schnittansicht durch ein Bauteil gemäss einer ersten erfindungsgemässen Ausführungsform gezeigt. Das Bauteil weist ein aus Kunststoff hergestelltes Trägerteil 1 auf, welches die darauf angebrachten und nachfolgend erläuterten Schichten 3, 4 und 5 trägt. Das Trägerteil 1 weist eine Vorderseite 11 und eine Rückseite 12 sowie eine das Trägerteil 1 umrandende Seitenfläche 13 auf, welche die Vorderseite 11 und die Rückseite 12 miteinander verbindet. In der vorliegenden Ausführungsform erstrecken sich die Vorderseite 11 und die Rückseite 12, die jeweils als Ganzes eben ausgebildet sind, parallel zueinander, und die Seitenfläche steht senkrecht zu diesen.

Um eine Hinterleuchtung durch das Trägerteil 1 hindurch zu ermöglichen, ist dieses bei der Ausführungsform der Figur 1 aus einem transluzenten oder transparenten Kunststoff hergestellt. In anderen Ausführungsformen, bei denen eine derartige Hinterleuchtung durch das Trägerteil 1 hindurch nicht notwendig oder erwünscht ist, kann das Trägerteil auch aus einem opaken Kunststoff hergestellt sein. Insbesondere geeignet als Kunststoffe für die Herstellung des Trägerteils 1 sind ABS, ABS / PC, PMMA und PC. Auch Kombinationen sind möglich, bei denen das Trägerteil 1 zum Bespiel bereichsweise aus einem transluzenten oder transparenten Material und bereichsweise aus einem opaken Material hergestellt ist. Das Trägerteil 1 weist dann also zumindest zwei verschiedene Kunststoffkomponenten auf. Auf diese Weise können bestimmte optische Effekte erzeugt und beispielsweise ein Schriftzug oder ein Symbol dargestellt werden. Um einer allfälligen unterschiedlichen Wärmeausdehnung des opaken Kunststoffs einerseits und des transluzenten bzw. transparenten Kunststoffs andererseits entgegenzuwirken, können in den jeweiligen Kunststoffen Füllstoffe vorgesehen sein, welche die unterschiedlichen Wärmeausdehnungen ausgleichen.

Bevorzugt sind insbesondere Kunststoffe, an denen die am Trägerteil 1 angebrachte und weiter unten näher erläuterte Farbschicht 3 gut haftet. Insbesondere im Randbereich des Trägerteils 1, also im Bereich der Seitenfläche 13, wird bevorzugt ein Kunststoff eingesetzt, welcher eine gute Haftung zur Farbschicht 13 bewirkt. Im Randbereich des Trägerteils 1 kann also ein Kunststoff verwendet werden, der eine vergleichsweise bessere Haftung an der Farbschicht 13 bewirkt als der Kunststoff des restlichen Trägerteils 1.

Das Trägerteil 1 ist bevorzugt als Ganzes einstückig im Spritzgussverfahren hergestellt.

Auf der Vorderseite 11 des Trägerteils 1 ist die Farbschicht 3 aufgebracht. Die Farbschicht 3 ist dabei fest mit dem Trägerteil 1 verbunden, das heisst das Material der Farbschicht 3 haftet über die gesamte Kontaktfläche hinweg am Material des Trägerteils 1.

Die Farbschicht 3 dient dazu, dem Bauteil eine charakteristische metallene Farbe zu verleihen und beim Betrachter den Eindruck einer metallischen Oberfläche zu bewirken. Um dies zu erreichen, ist die Farbschicht 3 aus Kupfer oder aus einer Kupferlegierung hergestellt, wobei der Kupferanteil bei mindestens 30%, bevorzugt bei mindestens 50%, liegt. Falls es sich um eine Kupferlegierung handelt, kann es insbesondere Messing oder Bronze sein. Diese Metalle bzw. Metalllegierungen verleihen dem Bauteil jeweils eine typische und charakteristische Farbe, die beim Betrachter den Eindruck einer hochwertigen Oberfläche bewirkt. Die Farbschicht 3 hat bevorzugt eine Schichtdicke von 20 - 200 nm.

Zur Herstellung des Bauteils wird das Material der Farbschicht 3 bevorzugt mittels PVD auf das Trägerteil 1 aufgebracht. Die Aufbringung mittels PVD bewirkt nicht nur eine sehr gute Haftung der Farbschicht 3 am Trägerteil 1, sondern ermöglicht auch die Herstellung einer besonders dünnen Farbschicht 3, deren Dicke gleichzeitig genau einstellbar ist. Auf diese Weise kann die Farbschicht 3 bzgl. ihrer Dicke insbesondere so bemessen werden, dass sie einerseits die gewünschte optische Wirkung, d.h. ein "Metall-Look", erzielt, und dass sie andererseits gleichzeitig eine ausreichende Transluzenz oder Transparenz aufweist, um vom Licht, das zwecks Hinterleuchtung des Bauteils von der Rückseite her eingestrahlt wird, durchstrahlt werden zu können. Das Licht kann somit durch die Farbschicht 3 hindurchtreten.

Um die Farbschicht 3 und insbesondere das darin enthaltene Kupfer vor Korrosion zu schützen ist auf die Vorderseite der Farbschicht 3 eine Korrosionsschutzschicht 4 aufgebracht. Die Korrosionsschutzschicht 4 ist aus einem der Elemente AI, Sc, V, Fe, Nb, Mo, Cr, Zr, Ti, Ag, Hf, Ta, W, Au, Pt oder deren Legierungen hergestellt. Es hat sich herausgestellt, dass von diesen erwähnten Elementen insbesondere Chrom und Zirkonium sowie deren Legierungen das darunterliegende Kupfer bzw. die darunterliegende Kupferlegierung nicht nur sehr effizient vor Korrosion schützen, sondern sich auch gut für die Herstellung des Bauteils eignen und zudem verhältnismässig kostengünstig sind. Ebenfalls gut geeignet sind Aluminium, Titan sowie deren Legierungen.

Das Material der Korrosionsschutzschicht 4 ist bevorzugt mittels PVD auf der Farbschicht 3 aufgebracht. Die Aufbringung mittels PVD bewirkt eine besonders gute Haftung der Korrosionsschutzschicht 4 an der Farbschicht 3 und ermöglicht zudem die Herstellung einer Korrosionsschutzschicht 4 mit einer sehr geringen, aber gleichzeitig genau einstellbaren Dicke. Auf diese Weise kann die Korrosionsschutzschicht 4 bzgl. ihrer Dicke insbesondere derart bemessen werden, dass sie einerseits den Korrosionsschutz gewährleistet und andererseits eine ausreichende Transluzenz oder Transparenz aufweist, um vom Licht, das zwecks Hinterleuchtung des Bauteils von der Rückseite her eingestrahlt wird, durchstrahlt werden zu können. Das Licht kann somit durch die Korrosionsschutzschicht 4 hindurchtreten und zum Betrachter hin gelangen.

Um das Bauteil und insbesondere die Farbschicht 3 sowie die Korrosionsschutzschicht 4 vor mechanischer Beschädigung und Umwelteinflüssen zu schützen, ist auf der Vorderseite der Korrosionsschutzschicht 4 eine Deckschicht 5 aufgebracht, welche diese vollständig überdeckt.

Die Deckschicht 5 kann zudem dazu dienen, dem Bauteil eine bestimmte optische Wirkung zu verleihen. So kann die Deckschicht 5 für den Betrachter je nachdem zum Beispiel eine glänzende oder eine matte Oberfläche bewirken. Die Deckschicht kann auch eingefärbt sein, um beispielsweise die von der Farbschicht 3 bewirkte Farbe fein zu justieren.

Bevorzugt ist die Deckschicht 5 aus einem UV-härtenden Lack, beispielsweise einem Klarlack, im Sprühverfahren hergestellt. Der Lack kann insbesondere eine Hochglanz- oder Seidenglanz-Optik aufweisen. Die Schichtdicke der Deckschicht 5 liegt bevorzugt bei 10 - 40 µm.

Um die Hinterleuchtung des Bauteils zu ermöglichen, ist die Deckschicht 5 aus einem transluzenten oder einem transparenten Material hergestellt, so dass das rückseitig in das Bauteil eingestrahlte Licht durch alle Schichten sowie die Deckschicht 5 hindurch nach vorne zum Betrachter hin gelangen kann.

Das Trägerteil 1, die Farbschicht 3, die Korrosionsschutzschicht 4 sowie die Deckschicht 5 sind jeweils in ein Gehäuse 10 eingefasst, welches die Seitenflächen des Trägerteil 1, der Farbschicht 3 und der Korrosionsschutzschicht 4 jeweils vollständig überdeckt sowie die Seitenfläche der Deckschicht 5 zumindest teilweise überdeckt. Das Gehäuse 10 ist bevorzugt aus einem opaken Material ausgebildet. Das Gehäuse 10 kann dadurch insbesondere dazu dienen, zu verhindern, dass Licht seitlich aus dem Bauteil austritt.

Bevorzugt ist das Trägerteil 1 mittels eines Spritzgussverfahrens hergestellt. Bevorzugt ist das Gehäuse 10 mittels eines Spritzgussverfahren hergestellt. Besonderes bevorzugt ist die Anordnung umfassend das Trägerteil 1 sowie das Gehäuse 10 mittels eines Mehrkomponentenspritzgussverfahrens, insbesondere mittels eines Zweikomponentenspritzgussverfahrens, hergestellt.

Auf der Rückseite des Trägerteils 1 ist ein Leuchtelement L angeordnet, welches zum Einkoppeln von Licht in das Trägerteil 1 hinein dient. Das Trägerteil 1 bildet somit einen Lichtleiter, welcher zum Transportieren und Verteilen des eingestrahlten Lichts dient. Beim Leuchtelement L kann es sich insbesondere um eine oder mehrere LEDs handeln. Das Leuchtelement L kann, muss aber nicht, ein Teil des Bauteils bilden und fest an diesem angebracht sein.

In der Figur 2 ist eine weitere Ausführungsform eines erfindungsgemässen Bauteils gezeigt, welche nachfolgend anhand der Unterschiede gegenüber der Ausführungsform der Figur 1 erläutert wird.

Im Vergleich zur Ausführungsform der Figur 1 ist bei derjenigen der Figur 2 zwischen dem Trägerteil 1 und der Farbschicht 3 zusätzlich eine Primerschicht 2 vorgesehen. Die Primerschicht 2 kann als Haftvermittler dienen und/oder kann dazu dienen, allfällige Oberflächenunebenheiten des Trägerteils 1 auszugleichen. Insbesondere kann die Primerschicht 2 aus einem UV-härtenden, transparenten Lack gebildet sein. Die Primerschicht 2 hat bevorzugt eine Schichtdicke von 5 - 30 µm.

Des Weiteren unterscheidet sich das Bauteil der Figur 2 insbesondere im Randbereich von demjenigen der Figur 1: In der Querschnittsansicht ist das Bauteil, wie in der Figur 2 erkennbar ist, in den Randbereichen jeweils von vorne nach hinten gerundet ausgebildet. Die Rundung ist in Bezug auf die Vorderseite bzw. Sichtseite des Bauteils bevorzugt umlaufend ausgebildet. Aufgrund der Rundung, welche das Trägerteil 1 sowie sämtliche Schichten 2 - 5 betrifft, kann dem Bauteil einen ästhetisch ansprechenden randseitigen Abschluss verliehen werden. Ausserdem können dadurch mechanische Beschädigungen sowie Schmutzablagerungen im Bereich der randseitigen Kanten eher vermieden werden.

Aufgrund der seitlichen Rundung gehen die Vorderseite des Trägerteils 1 sowie die Vorderseiten von allen Schichten 2 - 5 im Randbereich jeweils, wie in der Figur 2 erkennbar, via eine Rundung von 90° in eine Seitenfläche über, welche in einem Winkel von 90° zur jeweiligen Vorder- und Rückseite steht und bevorzugt umlaufend um das Bauteil ausgebildet ist. Die Seitenfläche 13 des Trägerteils 1 verbindet somit die Vorderseite 11 und die Rückseite 12 des Trägerteils 1 miteinander. Analog dazu verbinden die Seitenflächen der Schichten 2 - 5 jeweils deren jeweilige Vorder- und Rückseite miteinander.

Beim vorliegenden Ausführungsbeispiel weisen das Trägerteil 1 sowie die Primerschicht 2, die Farbschicht 3 und die Korrosionsschutzschicht 4 jeweils eine horizontal von der jeweiligen Seitenfläche nach aussen hin verlaufende Randerstreckung auf, welche vorteilhaft umlaufend vorgesehen ist. Die Randerstreckung des Trägerteils 1 erstreckt sich dabei, wie in der Figur 2 zu erkennen ist, weiter nach aussen hin als diejenigen der Primerschicht 2, der Farbschicht 3 und der Korrosionsschutzschicht 4. Das Trägerteil 1 erstreckt sich zudem von der Randerstreckung aussenseitig nochmals etwas nach vorne hin, so dass sich eine weitere Seitenfläche 13 ergibt, welche, wie in der Figur 2 erkennbar ist, einen seitlichen äusseren Abschluss des Trägerteils 1 bildet. Der sich nach vorne erstreckende äussere Teil des Trägerteils 1 kontaktiert mit seinem vorderen Ende die Deckschicht 5, so dass die Primerschicht 2, die Farbschicht 3 und die Korrosionsschutzschicht 4 jeweils vollständig im Trägerteil 1 und in der Deckschicht 5 eingebettet sind. Insbesondere sind die Randbereiche und insbesondere die Seitenflächen der Primerschicht 2, der Farbschicht 3 und der Korrosionsschutzschicht 4 jeweils vollständig vom Trägerteil 1 und der Deckschicht 5 abgedeckt. Die Primerschicht 2, die Farbschicht 3 und die Korrosionsschutzschicht 4 gelangen dadurch an keiner Stelle des Bauteils nach aussen und sind somit besonders gut vor Umwelteinflüssen geschützt.

Das Bauteil der Figur 2 weist zudem im Gegensatz zu demjenigen der Figur 1 kein Leuchtelement L auf. Das Trägerteil 1 und die Farbschicht 3 können deshalb hier auch opak ausgebildet sein.

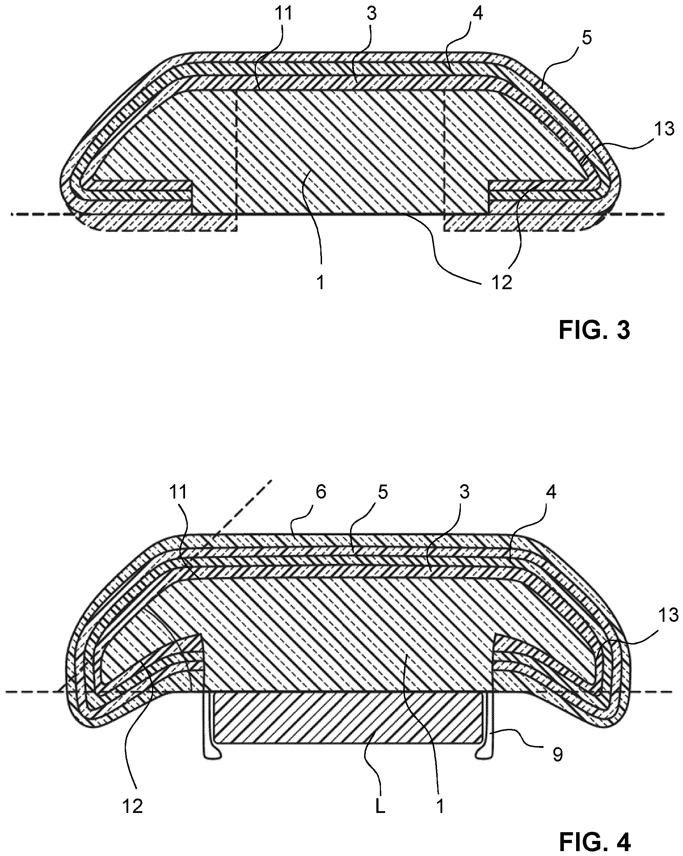

Eine weitere erfindungsgemässe Ausführungsform ist in der Figur 3 gezeigt, bei welcher das Trägerteil 1 in der Querschnittsansicht eine pilzförmige Ausgestaltung hat. Der Pilzhut oder Pilzschirm, dessen Vorderseite zu den Randbereichen hin jeweils leicht nach hinten gebogen ist, ist dabei sowohl nach vorne hin wie auch seitlich und nach hinten hin jeweils vollständig von der Farbschicht 3, der Korrosionsschutzschicht 4 sowie der Deckschicht 5 überdeckt. Die Rückseite 12 des Trägerteils 1 im Bereich des Pilzhuts bzw. Pilzschirms ist somit vollständig von den erwähnten Schichten 3 - 5 überdeckt. Da sich die Farbschicht 3 und die Korrosionsschutzschicht 4 rückseitig jeweils bis zu dem durch das Trägerteil 1 gebildeten Pilzstiel hin erstrecken und dort zudem vollständig von der Deckschicht 5 überdeckt werden, sind die Farbschicht 3 und die Korrosionsschutzschicht 4 auch bei dieser Ausführungsform jeweils komplett im Trägerteil 1 und in der Deckschicht 5 eingebettet. Die Farbschicht 3 und die Korrosionsschutzschicht 4 sind dadurch besonders gut vor externen Einflüssen geschützt.

Die Deckschicht 5 kann den durch das Trägerteil 1 gebildeten Pilzstiel rückseitig zumindest teilweise überdecken, wie in der Figur 3 durch den gestrichelt dargestellten Bereich gezeigt ist.

Die Ausführungsform der Figur 4 unterscheidet sich unter anderem dadurch von derjenigen der Figur 3, dass der Pilzhut oder Pilzschirm nicht nur mit seiner Vorderseite, sondern auch mit seiner Rückseite und somit als Ganzes zu den Randbereichen hin jeweils leicht nach hinten gebogen ist. Ausserdem ist bei der Ausführungsform der Figur 4 eine weitere Deckschicht 6 vorgesehen, welche die gesamte erste Deckschicht 5 überdeckt.

Die weitere Deckschicht 6 ist bevorzugt aus einem anderen Material hergestellt als die erste Deckschicht 5 und kann beispielsweise dazu dienen, dem Bauteil einen zusätzlichen Schutz oder einen anderen optischen Eindruck (z.B. Farbe oder Glanz) zu verleihen. Im Material der weiteren Deckschicht 6 können somit wie auch in demjenigen der Deckschicht 5 zum Beispiel Farbstoffe, insbesondere Farbpigmente, vorgesehen sein. Bei der zweiten Deckschicht 6 kann es sich zum Beispiel auch um eine abziehbare Schutzschicht, insbesondere um eine abziehbare Schutzfolie, handeln, um das Bauteil und insbesondere die erste Deckschicht 5 bei Lagerung und Transport zu schützen.

Rückseitig sind am Trägerteil 1 Rastelemente 9 angebracht oder einstückig daran angeformt, welche sich jeweils vor der durch den Pilzstiel gebildeten Rückseite des Trägerteils 1 aus senkrecht nach hinten erstrecken. Das Trägerteil 1 mit den Rastelementen 9 kann zum Beispiel mittels Zweikomponentenspritzguss hergestellt sein. Die Rastelemente 9 können dabei aus einem unterschiedlichem oder aus einem identischen Kunststoff hergestellt sein wie das Trägerteil 1.

Die Rastelemente 9 dienen zur Halterung eines hier plattenförmig ausgebildeten Leuchtelements L, welches zur Hinterleuchtung des Bauteils dient. Das Bauteil kann beispielsweise ein Bildschirm sein. Das Trägerteil 1 ist somit hier bevorzugt transluzent oder transparent ausgebildet und bildet einen Lichtleiter. Ebenso sind bevorzugt die Farbschicht 3, die Korrosionsschutzschicht 4, die Deckschicht 5 sowie die weitere Deckschicht 6 jeweils transluzent oder transparent ausgebildet. Wenn die weitere Deckschicht 6 eine abziehbare Schutzschicht bildet, kann sie aber auch opak ausgebildet sein.

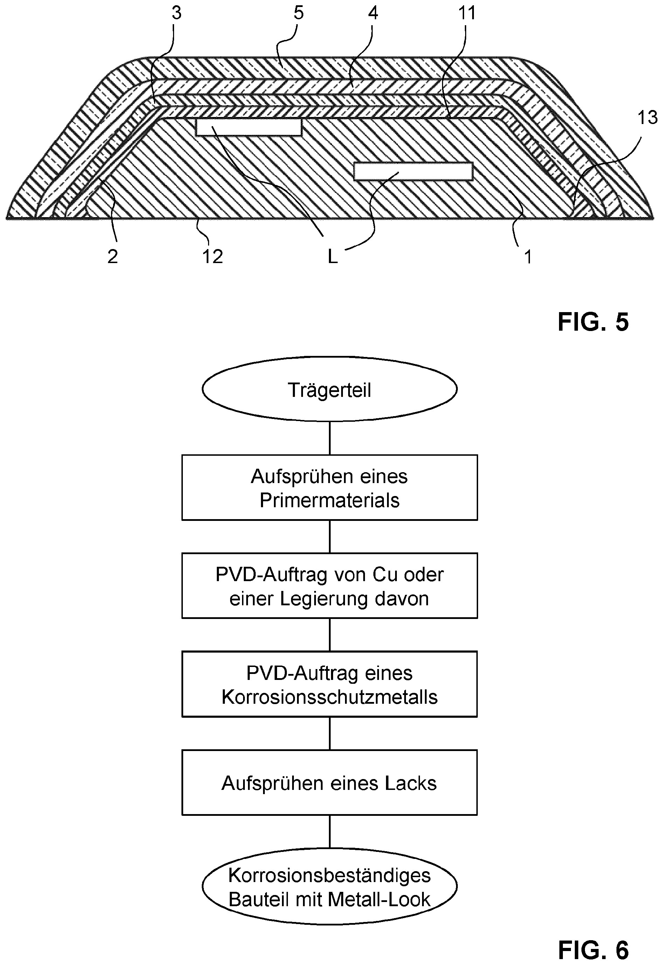

Bei der erfindungsgemässen Ausführungsform der Figur 5 weist das Bauteil in der Querschnittsansicht die Form eines gleichschenkligen Trapezes auf. Ähnlich wie bei der Ausführungsform der Figur 2 ist auch hier zwischen Trägerteil 1 und Farbschicht 3 eine Primerschicht 2 vorhanden, welche als Haftvermittler und/oder zum Ausgleichen von Oberflächenunebenheiten des Trägerteils 1 dient. Die Primerschicht 2, die Farbschicht 3, die Korrosionsschutzschicht 4 und die Deckschicht 5 bedecken jeweils die Vorderseite 11 sowie die Seitenfläche 13 des Trägerteils 1 vollständig.

Im vorliegenden Ausführungsbeispiel sind plattenförmige Leuchtelemente L im Inneren des Trägerteils 1 angeordnet. Die Leuchtelemente L können dabei vollständig vom Material des Trägerteils 1 umgeben oder in eine Aussparung an der Oberfläche, insbesondere an der Vorderseite 11, des Trägerteils 1 eingesetzt sein. Im Falle, dass das Leuchtelement L vollständig im Inneren des Trägerteils 1 angeordnet ist, ist das Trägerteil 1 transluzent oder transparent ausgebildet, so dass das vom Leuchtelement ausgestrahlte Licht vom Trägerteil 1 aus in die Schichten 3 - 5 und von dort aus nach aussen zum Betrachter gelangen kann. Falls das Leuchtelement L in einer an der Vorderseite 11 vorgesehenen Aussparung angeordnet ist, kann das Trägerteil hingegen auch opak ausgebildet sein. Eine derartige Einbettung von einem oder mehreren Leuchtelementen L im Inneren oder an einer Oberfläche des Trägerteils 1 kann insbesondere bei der Herstellung des Trägerteils 1 im Spritzgussverfahren durch Umspritzen des bzw. der Leuchtelemente L erreicht werden.

Um eine bessere Lichtausbeute zu erzielen und/oder um bestimmte optische Effekte zu erzeugen, kann das Bauteil Lichtumlenkstrukturen aufweisen. Die Lichtumlenkstrukturen können gemeinsam zum Beispiel einen Schriftzug oder ein Logo bilden. Durch das Vorsehen von Lichtumlenkstrukturen kann eine gezielte Lichtumlenkung des von einem oder mehreren Leuchtelementen L ausgestrahlten Lichtes in eine oder mehrere bestimmte Richtungen oder in einen oder mehrere bestimmte Richtungsbereiche erreicht werden. Die Lichtumlenkstrukturen, welchen in den Figuren nicht gezeigt sind, können in Form von Vertiefungen und/oder Erhebungen an der Oberfläche des Trägerteils 1 und/oder an der Oberfläche von einer oder mehreren der Schichten 2, 3, 4 oder 5 ausgebildet sein. Alternativ oder zusätzlich können die Lichtumlenkstrukturen zum Beispiel als Materialveränderungen im Inneren des Trägerteils 1 und oder im Inneren von einer oder mehreren der Schichten 2, 3, 4 oder 5 ausgebildet sein. Besonders einfach ist die Herstellung, wenn die Lichtumlenkstrukturen mit Hilfe eines Lasers erzeugt sind.

In der Figur 6 ist in einem Flussdiagramm schematisch das Verfahren zur Herstellung des erfindungsgemässen Bauteils illustriert: In einem ersten Schritt wird aus einem Kunststoff ein Trägerteil 1 hergestellt, wozu vorzugsweise ein Spritzgussverfahren angewandt wird. Bevorzugt wird ein Primermaterial auf das Trägerteil 1 aufgesprüht, um zwecks Ausgleichung von Oberflächenunebenheiten und/oder zur Verbesserung der Haftung eine Primerschicht zu bilden. Anschliessend wird das Trägerteil 1 mit der gegebenenfalls vorhandenen Primerschicht, bevorzugt mittels PVD, mit Kupfer (Cu) oder einer Kupferlegierung beschichtet, welche eine Farbschicht bildet, das heisst dem Bauteil ein charakteristisches Aussehen und insbesondere Farbe verleiht. Um die Farbschicht vor Korrosion zu schützen, wird diese mit einer Korrosionsschutzschicht beschichtet, welche aus einem Korrosionsschutzmetall hergestellt ist, das eines oder mehrere der Elemente Al, Sc, V, Fe, Nb, Mo, Cr, Zr, Ti, Ag, Hf, Ta, W, Au, Pt oder deren Legierungen umfasst. Zum Auftragen des Korrosionsschutzmetalls auf der Farbschicht wird bevorzugt ein PVD-Verfahren angewandt. Die Korrosionsschutzschicht wird dabei so dünn ausgebildet, dass sie transluzent oder transparent ist, so dass die Farbschicht durch die Korrosionsschutzschicht hindurch sichtbar bleibt. Anschliessend wird zum Schutz der Farbschicht und der Korrosionsschutzschicht vor externen Einflüssen eine Deckschicht gebildet, was bevorzugt mittels Aufbringen eines Lacks im Sprühverfahren erreicht wird. Der Lack ist transluzent oder transparent, so dass die Farbschicht für den Betrachter sichtbar bleibt. Als Ergebnis wird ein korrosionsbeständiges Bauteil erhalten, das einen charakteristischen Metall-Look aufweist.

In einem konkret durchgeführten Experiment wurden vier Trägerteile mit Kupfer- bzw. Messingbeschichtet, mit jeweils einem Schichtaufbau ähnlich wie er in der Figur 1 dargestellt ist. Bei zwei Bauteilen wurde jeweils im PVD-Verfahren eine aus Kupfer hergestellte Farbschicht 3 mit einer Schichtdicke von ca. 50-100 nm realisiert, wobei im ersten Fall keine Korrosionsschutzschicht vorgesehen wurde und im zweiten Fall eine aus Chrom hergestellte PVD-Korrosionsschutzschicht 4 direkt auf die Farbschicht 3 aufgebracht wurde. Bei zwei weiteren Bauteilen wurde jeweils eine aus Messing hergestellte PVD-Farbschicht 3 mit einer Schichtdicke von ca. 50-100 nm realisiert, wobei auch hier im ersten Fall keine Korrosionsschutzschicht vorgesehen wurde und im zweiten Fall eine aus Chrom hergestellte PVD-Korrosionsschutzschicht 4 direkt auf die Farbschicht 3 aufgebracht wurde. Die Korrosionsschutzschichten wiesen jeweils eine Schichtdicke von 3 - 5 nm auf. Somit wurden vier Bauteile gemäss den in der nachfolgenden Tabelle 1 angegebenen Spezifikationen hergestellt:

**Tabelle 1: In einem Experiment hergestellte Bauteile**

| **Bauteil Nr.** | **PVD-Schichten** | **Farbe** | **Schichten** | **Schichtdicke** |
|---|---|---|---|---|
| **1** | Kupfer ungeschützt | rose | Kupfer | 50-100 nm |
| **2** | Kupfer geschützt | rose | Kupfer Chrom | 50-100 nm 3-5 nm |
| **3** | Messing ungeschützt | Gold-gelb | Messing | 50-100 nm |
| **4** | Messing geschützt | Gold-gelb | Messing Chrom | 50-100 nm 3-5 nm |

Die derart hergestellten und in Tabelle 1 angegebenen Bauteile wurden anschliessend verschiedenen Belastungstests unterzogen. Folgende dem Fachmann bekannte Tests wurden hierzu durchgeführt:
- Heisswasserlagerung (3 Tage lang bei 70°C);
- Klimawechseltest PV1200 nach VW TL211 (Ausgabe 2021-07);
- Kondenswasserkonstantklimatest nach VW TL226 (DIN EN ISO 6270-2 CH, Ausgabe April 2018);
- Salzsprühnebeltest nach kundenspezifischer Vorgabe (250h, 40°C, 5% Salz).

Die nachfolgende Tabelle 2 gibt die gemessenen Farbwerte im L*a*b-Farbraum der vier Bauteile vor und nach Durchführen der dreitägigen Wasserlagerung bei 70°C sowie die ΔE-Werte nach Wasserlagerung an:

**Tabelle 2: Gemessene L*a*b-Farbwerte vor und nach Wasserlagerung**

| **Bauteil Nr.** | **vor / nach Wasserlagerung** | **L*** | **a*** | **b*** | **ΔE** |
|---|---|---|---|---|---|
| **1** | vorher | 78.81 | 12.97 | 14.96 | - |
| **1** | nachher | 69.75 | 12.44 | 21.11 | 10.96 |
| **2** | vorher | 73.34 | 12.95 | 13.57 | - |
| **2** | nachher | 70.42 | 11.85 | 14.05 | 3.16 |
| **3** | vorher | 85.44 | 0.65 | 24.73 | - |
| **3** | nachher | n/a | n/a | n/a | n/a |
| **4** | vorher | 80.28 | 1.99 | 22.71 | - |
| **4** | nachher | 75.43 | 3.50 | 25.78 | 5.94 |

Aus Tabelle 2 ist gut erkennbar, dass vor dem Belastungstest die Farbunterschiede der mit einer Korrosionsschutzschicht versehenen Bauteile im Vergleich zu den ungeschützten Bauteilen jeweils sehr gering sind. Die aufgrund der Wasserlagerung entstandenen Farbveränderungen sind bei den Bauteilen Nr. 2 und 4 mit Korrosionsschutzschicht jeweils nur gering ausgefallen. Im Gegensatz dazu konnte beim ungeschützten Bauteil Nr. 1 nach Belastung eine erhebliche Farbveränderung festgestellt werden. Beim ebenfalls ungeschützten Bauteil Nr. 3 war nach der Belastung eine Farbmessung gar nicht mehr möglich, da die Farbschicht derart korrodiert war, dass sich die Deckschicht (Topcoat) von dieser abgelöst hat und das Bauteil dadurch zerstört war.

Die nachfolgende Tabelle 3 gibt die gemessenen Farbwerte im L*a*b-Farbraum der vier Bauteile vor und nach Durchführen des Klimawechseltests PV1200 nach VW TL211 sowie die ΔE-Werte nach PV1200 an:

**Tabelle 3: Gemessene L*a*b-Farbwerte vor und nach Klimawechseltest PV1200**

| **Bauteil Nr.** | **vor / nach PV1200** | **L*** | **a*** | **b*** | **ΔE** |
|---|---|---|---|---|---|
| **1** | vorher | 74.52 - | 12.00 - | 10.10 - | - |
| | | 75.74 | 12.33 | 11.38 | |
| **1** | nachher | 56.94 | 8.52 | 16.38 | 22.36 |
| **2** | vorher | 72.64 - 73.52 | 12.08 - 12.40 | 10.25 - 10.84 | - |
| **2** | nachher | 72.53 | 11.52 | 10.16 | 3.79 |
| **3** | vorher | 85.15 - 85.79 | 0.53 - 0.76 | 24.49 - 24.74 | - |
| **3** | nachher | 42.42 | 2.25 | 17.99 | 43.57 |
| **4** | vorher | 80.24 - 80.82 | 1.90 - 2.16 | 22.61 - 23.18 | - |
| **4** | nachher | 80.50 | 1.64 | 24.85 | 2.18 |

Aus Tabelle 3 ist gut erkennbar, dass vor dem Belastungstest die Farbunterschiede der mit einer Korrosionsschutzschicht versehenen Bauteile im Vergleich zu den ungeschützten Bauteilen jeweils sehr gering sind. Die aufgrund der Belastung entstandenen Farbveränderungen sind bei den Bauteilen Nr. 2 und 4 mit Korrosionsschutzschicht jeweils nur gering ausgefallen. Im Gegensatz dazu konnten bei den ungeschützten Bauteilen Nr. 1 und Nr. 3 nach PV1200-Belastung jeweils eine erhebliche Farbveränderung festgestellt werden.

Die nachfolgende Tabelle 4 gibt die gemessenen Farbwerte im L*a*b-Farbraum der vier Bauteile vor und nach Durchführen des Kondenswasserkonstantklimatests nach VW TL226 sowie die ΔE-Werte nach Kondenswasserkonstantklimatest an:

**Tabelle 4: Gemessene L*a*b-Farbwerte vor und nach Kondenswasserkonstantklimatest nach VW TL226**

| **Bauteil Nr.** | **vor / nach Kondenswassertest** | **L*** | **a*** | **b*** | **ΔE** |
|---|---|---|---|---|---|
| **1** | vorher | 74.52 - 75.74 | 12.00 - 12.33 | 10.10 - 11.38 | - |
| **1** | nachher | 72.31 | 10.98 | 11.94 | 7.44 |
| **2** | vorher | 72.64 - 73.52 | 12.08 - 12.40 | 10.25 - 10.84 | - |
| **2** | nachher | 72.55 | 11.78 | 10.29 | 3.57 |
| **3** | vorher | 85.15 - | 0.53 - 0.76 | 24.49 - | - |
| | | 85.79 | | 24.74 | |
| **3** | nachher | 69.03 | 3.23 | 30.41 | 17.56 |
| **4** | vorher | 80.24 - 80.82 | 1.90 - 2.16 | 22.61 - 23.18 | - |
| **4** | nachher | 80.34 | 2.10 | 23.04 | 0.35 |

Aus Tabelle 4 ist gut erkennbar, dass vor dem Belastungstest die Farbunterschiede der mit einer Korrosionsschutzschicht versehenen Bauteile im Vergleich zu den ungeschützten Bauteilen jeweils sehr gering sind. Aufgrund der Kondenswasser-Belastung konnte beim ungeschützten Messing-Bauteil Nr. 3 eine erhebliche Farbveränderung festgestellt werden. Im Gegensatz dazu ist die Farbveränderung beim Messing-Bauteil Nr. 2 mit Korrosionsschutzschicht aber nur gering ausgefallen. Beim ungeschützten Kupfer-Bauteil Nr. 1 war die Farbveränderung nach Belastung eher gering, aber grösser als beim geschützten Kupfer-Bauteil Nr. 2.

Die nachfolgende Tabelle 5 gibt die gemessenen Farbwerte im L*a*b-Farbraum der vier Bauteile vor und nach Durchführen des Salzsprühnebeltests (250h, 40°C, 5% Salz) sowie die ΔE-Werte nach Salzsprühnebeltest an:

**Tabelle 5: Gemessene L*a*b-Farbwerte vor und nach Salzsprühnebeltest nach VW TL226**

| **Bauteil Nr.** | **vor / nach Salzsprühnebeltest** | **L*** | **a*** | **b*** | **ΔE** |
|---|---|---|---|---|---|
| **1** | vorher | 74.52 - 75.74 | 12.00 - 12.33 | 10.10 - 11.38 | - |
| **1** | nachher | 73.20 | 11.38 | 11.95 | 6.56 |
| **2** | vorher | 72.64 - 73.52 | 12.08 - 12.40 | 10.25 - 10.84 | - |
| **2** | nachher | 72.83 | 11.87 | 10.19 | 3.58 |
| **3** | vorher | 85.15 - 85.79 | 0.53 - 0.76 | 24.49 - 24.74 | - |
| **3** | nachher | 67.94 | 3.06 | 34.34 | 20.11 |
| **4** | vorher | 80.24 - 80.82 | 1.90 - 2.16 | 22.61 - 23.18 | - |
| **4** | nachher | 80.51 | 1.98 | 23.49 | 0.81 |

Aus Tabelle 5 ist wiederum gut erkennbar, dass vor dem Belastungstest die Farbunterschiede der mit einer Korrosionsschutzschicht versehenen Bauteile im Vergleich zu den ungeschützten Bauteilen jeweils sehr gering sind. Aufgrund der Sprühnebel-Belastung konnte beim ungeschützten Messing-Bauteil Nr. 3 eine erhebliche Farbveränderung festgestellt werden. Eine insbesondere ausgeprägte Farbveränderung ergab sich dabei im Randbereich des Bauteils. Im Gegensatz dazu ist die Farbveränderung beim Messing-Bauteil Nr. 4 mit Korrosionsschutzschicht aber nur gering ausgefallen. Beim ungeschützten Kupfer-Bauteil Nr. 1 war die Farbveränderung nach Belastung zwar gering. Allerdings entstanden aufgrund von jeweils lokal begrenzter Korrosion eine Vielzahl von schwarzen Stellen, welche beim geschützten Bauteil Nr. 2 nach Belastung nicht vorhanden waren.

**BEZUGSZEICHENLISTE**

| | | | |
|---|---|---|---|
| 1 | Trägerteil | 5 | Deckschicht |
| 11 | Vorderseite | 6 | Deckschicht |
| 12 | Rückseite | | |
| 13 | Seitenfläche | 9 | Rastelement |
| | | 10 | Gehäuse |
| 2 | Primerschicht | | |
| 3 | Farbschicht | L | Leuchtelement |
| 4 | Korrosionsschutzschicht | | |

## Patentansprüche

1. Bauteil mit korrosionsbeständiger Kupferbeschichtung, aufweisend ein Trägerteil (1) aus Kunststoff;
eine auf das Trägerteil (1) aufgebrachte Farbschicht (3), welche aus Kupfer oder aus einer Kupferlegierung mit einem Kupferanteil von mindestens 30%, wie insbesondere Bronze oder Messing, hergestellt ist;
eine auf die Farbschicht (3) aufgebrachte transluzente oder transparente Korrosionsschutzschicht (4), welche aus einem oder mehreren der Elemente Al, Sc, V, Fe, Nb, Mo, Cr, Zr, Ti, Ag, Hf, Ta, W, Au, Pt oder deren Legierungen hergestellt ist; sowie
eine auf die Korrosionsschutzschicht (4) aufgebrachte transluzente oder transparente Deckschicht (5, 6),
**dadurch gekennzeichnet, dass**
die Korrosionsschutzschicht (4) direkt auf der Farbschicht (3) aufgebracht ist.

2. Das Bauteil nach Anspruch 1, wobei die Farbschicht (3) und/oder die Korrosionsschutzschicht (4) mittels physikalischer Gasphasenabscheidung (eng. physical vapour deposition, PVD) aufgebracht ist.

3. Das Bauteil nach Anspruch 1 oder 2, wobei die Korrosionsschutzschicht (4) derart ausgebildet ist, dass sie im L*a*b-Farbraum die von einem Betrachter wahrgenommene Farbe der Farbschicht (3) um einen Farbvektor verändert, der kürzer ist als 10 ΔE-Einheiten, insbesondere kürzer ist als 6 ΔE-Einheiten.

4. Das Bauteil nach einem der vorhergehenden Ansprüche, wobei die Korrosionsschutzschicht (4) eine Schichtdicke aufweist von 2 - 5 nm, bevorzugt von 2 - 4 nm.

5. Das Bauteil nach einem der vorhergehenden Ansprüche, wobei die Korrosionsschutzschicht (4) direkt auf einer Oberfläche der Farbschicht (3) aufgebracht ist, welche bzgl. der Oberflächenenergie unbehandelt ist, und welche insbesondere weder einer Corona- oder einer Plasmabehandlung unterzogen worden ist.

6. Das Bauteil nach einem der vorhergehenden Ansprüche, wobei die Deckschicht (5, 6) aus einem Lack und bevorzugt im Sprühverfahren hergestellt ist.

7. Das Bauteil nach einem der vorhergehenden Ansprüche, wobei zwischen Trägerteil (1) und Farbschicht (3) eine bevorzugt aus einem Lack hergestellte Primerschicht (2) vorgesehen ist, welche als Haftvermittler und/oder zur Ausgleichung von Oberflächenunebenheiten dient und vorteilhaft eine Schichtdicke aufweist von 5 - 30 µm.

8. Das Bauteil nach einem der vorhergehenden Ansprüche, wobei die Farbschicht (3) eine Schichtdicke aufweist von 20 - 200 nm.

9. Das Bauteil nach einem der vorhergehenden Ansprüche, wobei die Deckschicht (5) direkt auf der Korrosionsschutzschicht aufgebracht ist.

10. Das Bauteil nach einem der vorhergehenden Ansprüche, wobei die Farbschicht (3) und/oder das Trägerteil (1) transluzent oder transparent ausgebildet sind, und wobei das Bauteil ausserdem bevorzugt ein Leuchtelement (L) aufweist, um das Bauteil durch die Farbschicht (3) hindurch zu hinterleuchten.

11. Das Bauteil nach einem der vorhergehenden Ansprüche, das Trägerteil (1) bei bestimmungsgemässer Verwendung aufweisend
eine Vorderseite (11);
eine Rückseite (12); sowie
eine das Trägerteil (1) zumindest teilweise seitlich umrandende Seitenfläche (13), welche die Vorderseite (11) mit der Rückseite (12) verbindet,
wobei die Farbschicht (3), die Korrosionsschutzschicht (4) und bevorzugt die Deckschicht (5, 6) jeweils die Vorderseite (11) und die Seitenfläche (13) sowie allenfalls die Rückseite (12) zumindest teilweise überdecken.

12. Verfahren, welches insbesondere zur Herstellung eines Bauteils mit korrosionsbeständiger Kupferbeschichtung nach einem der vorhergehenden Ansprüche dient, aufweisend die folgenden Verfahrensschritte:
- Aufbringen einer Farbschicht (3) aus Kupfer oder aus einer Kupferlegierung mit einem Kupferanteil von mindestens 30%, wie insbesondere Bronze oder Messing, auf ein Trägerteil (1) aus Kunststoff; sowie
- Aufbringen einer transluzenten oder transparenten Korrosionsschutzschicht (4) aus einem oder mehreren der Elemente AI, Sc, V, Fe, Nb, Mo, Cr, Zr, Ti, Ag, Hf, Ta, W, Au, Pt oder deren Legierungen auf der Farbschicht (3);
- Aufbringen einer transluzenten oder transparenten Deckschicht (5, 6) auf der Korrosionsschutzschicht (4),
**dadurch gekennzeichnet, dass**
die Korrosionsschutzschicht (4) direkt auf der Farbschicht (3) aufgebracht wird.

13. Das Verfahren nach Anspruch 12, wobei das Aufbringen der Korrosionsschutzschicht (4) auf die Farbschicht (3) zeitlich unmittelbar nach dem Aufbringen der Farbschicht (3) auf das Trägerteil (1) erfolgt.
